# EUROPÄISCHE PATENTSCHRIFT

(11) **EP 3 022 781 B1**
(45) Veröffentlichungstag und Bekanntmachung des Hinweises auf die Patenterteilung: **31.01.2018**
(21) Anmeldenummer: 14728110.9
(22) Anmeldetag: 16.05.2014
(51) Int. Cl.: H01L 41/06, H02N 2/02, H01L 41/12, F16K 31/06

(54) **AKTUATORVORRICHTUNG**
ACTUATOR
ACTUATEUR

(30) Priorität: 19.07.2013 DE 102013107744
(43) Veröffentlichungstag der Anmeldung: 25.05.2016
(73) Patentinhaber: ETO MAGNETIC GMBH, 78333 Stockach (DE)
(72) Erfinder: SCHIEPP, Thomas, 78606 Seitingen-Oberflacht (DE); LAUFENBERG, Markus, 78333 Stockach (DE)
(74) Vertreter: Patentanwälte Behrmann Wagner PartG mbB
(86) Internationale Anmeldenummer: PCT/EP2014/060095
(87) Internationale Veröffentlichungsnummer: WO 2015/007416

(56) Entgegenhaltungen:
- WO-A1-2014/019738
- US-A1- 2004 206 922
- US-A1- 2006 044 093
- US-A1- 2010 242 673

## Beschreibung

Die vorliegende Erfindung betrifft eine Aktuatorvorrichtung nach dem Oberbegriff des Patentanspruchs 1. Eine derartige Vorrichtung ist aus der DE 10 2009 014 304 bekannt.

Aus diesem Stand der Technik (wie auch aus der zugrunde liegenden, als bekannt vorausgesetzten allgemeinen Aktuatortechnologie) ist es bekannt, magnetisch wirksame Formgedächtnis-Legierungsmaterialien (sog. MSM-Materialien = Magnetic Shape Memory, hier gleichbedeutend mit - magnetischer - FGL = Formgedächtnislegierung) für die Aktorik zu benutzen. So wird etwa typischerweise zu diesem Zweck ein MSM-(FGL-)Kristallkörper (als Repräsentant für eine Vielzahl von möglichen MSM-basierten Materialien), typischerweise hergestellt auf der Basis einer NiMnGa-Legierung, mit einem durch eine bestromte Spule erzeugten Magnetfeld beaufschlagt. Als Reaktion auf eine solche magnetische Feldbeaufschlagung führt der MSM-Krstiallkörper als Expansionskörper bzw. Expansionsmittel eine Expansionsbewegung durch, deren Hub in der Regel in einer Richtung senkrecht zur Durchflutungsrichtung mit dem elektromagnetisch erzeugten Feld verläuft. Diese Expansionsbewegung kann dann an einem angetriebenen Ende einen geeignet mit diesem Ende zusammenwirkenden Stellpartner, etwa einen oberbegrifflichen Stellkörper, antreiben.

Damit bieten derartige, magnetisch wirksame Formgedächtnis-Legierungsmaterialien und mit diesen in der beschriebenen prinzipiellen Art realisierte Aktuatoren (Aktuatorvorrichtungen) eine Möglichkeit, gängige magnetbasierte Aktuatorprinzipien - wie etwa elektromagnetische Aktuatoren - zu ersetzen bzw. zu ergänzen. Vorteilhaft ist bei dem verwendeten magnetischen Formgedächtnis-Legierungsmaterial neben konstruktiv-mechanischer Einfachheit in der Realisierung (es bewegt sich kein Anker als Ganzes, es findet lediglich eine Expansion der Expansionsmittel statt) vor allem eine potenziell schnelle Reaktionszeit der Expansion auf das Anliegen des Magnetfeldes.

Allerdings haben als bekannt vorausgesetzte, MSM-basierte Aktuatorvorrichtungen auch prinzip- bzw. konstruktionsbedingte Nachteile gegenüber anderen Aktuatorprinzipien, wodurch in der Praxis eine wirklich universelle Verwendbarkeit bislang eingeschränkt war. So ist etwa ein nutzbarer Hub einer longitudinalen Expansionsbewegung (d.h. ein Streckenmaß einer von dem MSM-Kristall durchgeführten Streckbewegung) typischerweise beschränkt auf ca. 3% bis 6% einer entsprechenden axialen Erstreckung des Kristalls, so dass gerade großhubige Bewegungen nur schwierig mittels FGL- bzw. MSM-Aktuatoren realisierbar sind.

Darüber hinaus weisen bekannte MSM-/FGL-Aktuatoren die Eigenschaft auf, dass als Reaktion auf ein angelegtes Magnetfeld (eine notwendige Mindestfeldstärke) zwar die beabsichtigte Expansionsbewegung stattfindet, nach einem Abfall dieses Magnetfeldes (unter die Mindestschwelle) dann jedoch nicht automatisch eine Kompression zurück in den ursprünglichen komprimierten Zustand stattfindet. Vielmehr verbleibt der Kristall (Expansionsmittel) in der expandierten Position. Aus dem Stand der Technik ist es daher bekannt, ein notwendiges Zurückstellen (d.h. das Zurückführen der Expansionsmittel in eine nicht-expandierte Ausgangslage) mit Rückstellmitteln zu realisieren, welche etwa als mechanische Feder ausgebildet sind. Eine derartige Feder übt ihre Federkraft entgegen der Expansionsrichtung aus. Wenn entsprechend die Federkraft einer solchen bekannten Rückstellfeder, gegenwirkend einem zu expandierenden FGL-Kristall, so eingerichtet ist, dass bei der Magnetfeldbeaufschlagung das FGL-Material der Expansionsmittel die Gegenkraft (Rückstellkraft) der Feder übersteigt, findet die beabsichtigte Expansionsbewegung statt. Fällt dann nach dem Ende der Bestromung das Magnetfeld ab (unter die notwendige Mindestfeldstärke), führt dagegen die auf das MSM-Krstall wirkende Federkraft zu einer Kontraktion zurück in die komprimierte Ausgangslage.

Insbesondere jedoch eine derartige, als aus dem Stand der Technik bekannt vorauszusetzende Rückstellung einer MSM-Aktuatorvorrichtung mittels (mechanischer oder auch magnetischer) Feder setzt jedoch voraus, dass die durch das Formgedächtnis-Legierungsmaterial zu erzeugende Stellkraft beim Anliegen des notwendigen Magnetfeldes stets größer sein muss als die mechanische (Rückstell-)Kraft des als Feder realisierten Rückstellelements, damit es überhaupt zu einer Expansions- und damit einer Stellbewegung kommt. Aufgrund einer typischerweise als linear ansteigend anzunehmende Kraft-Weg-Kennlinie einer mechanischen Rückstellfeder ist dies jedoch gerade in einer expandierten Endlage (d.h. zum Ende eines maximal möglichen Expansionshubs) von MSM-basierten Expansionsmitteln häufig nicht gegeben, so dass als mechanische Feder oder mittels Permanentmagneten realisierte Rückstellmittel, welche rückstellend auf die Expansionsmittel wirken, eine Nutzbarkeit eines maximalen Expansionshubes dieser MSM-Expansionsmittel faktisch beschränken, in der Praxis auf etwa 80% eines möglichen maximalen Expansionshubes.

Als aus dem Stand der Technik bekannt vorauszusetzen ist es ferner, ein Paar von mittels magnetisch wirksamen Formgedächtnis-Legierungsmaterialien realisierten Expansionsmitteln so mechanisch zu verkoppeln, dass diese gegeneinander wirken und so eine Expansion erster Stellmittel das Rückstellen der gekoppelten zweiten Stellmittel und umgekehrt bewirkt. Ein derartiges Prinzip, welches entweder zwei longitudinal verkoppelte, oder aber auch rotatorisch verkoppelte MSM-Aktuatorsysteme vorsieht, wird als Push-Push-System bezeichnet, verwiesen wird etwa auf die US 7,246,489 B2 zum erstgenannten Prinzip. Die als gattungsbildend genannte DE 10 2009 014 304 der Anmelderin verdeutlicht insoweit ein rotatorisch verkoppeltes System von zwei MSM-Stellmitteln, wobei hier ein Schwenkhebel die Kraftübertragung zwischen den Einzelaktuatoren bewirkt.

Vorteilhaft ist bei derartigen MSM-basierten Push-Push-Systemen auch der Umstand, dass der von beiden Einzelaktuatoren (geeignet longitudinal oder rotatorisch gegenläufig angetriebene) Stellkörper an praktisch jeder beliebigen Stellposition zwischen Endpositionen der jeweiligen Stellbewegungen stromlos stabil steht; mit anderen Worten, durch geeignete Ansteuerung ist ein derartiges, als gattungsbildend vorausgesetztes MSM-Push-Push-System in der Lage, den Stellkörper entlang des Bewegungspfades - bidirektional bewegt - in stromlos stabilen Positionen zu halten und so insbesondere Stellaufgaben durchzuführen, welche keine permanente Bestromung oder Positionsregelung benötigen, solange äußere Kräfte ein vorbestimmtes Niveau nicht überschreiten.

Während eine derartige Technologie weniger betroffen von dem vorstehend erläuterten Problem eines reduzierten maximalen Expansionshubes der MSM-Expansionsmittel ist, bedeutet gleichwohl die Realisierung eines derartigen Push-Push-Systems mittels zweier zusammenwirkender MSM-Aktuatoren beträchtlichen Hardware- und Bauteileaufwand, da ja für jedes Einzel-Stellglied nicht nur ein jeweiliger MSM-Expansionskörper notwendig, ist, sondern auch eine jeweils zugeordnete, das notwendige Magnetfeld erzeugende Spuleneinheit samt ggf. zusätzlicher Flussleitmittel sowie mechanischer Koppelelemente.

Aufgabe der vorliegenden Erfindung ist es daher, eine Aktuatorvorrichtung zu schaffen, welche einerseits die Nachteile eines mit Federkraft oder dgl. zurückgestellten MSM-Einzelaktuators im Hinblick auf einen begrenzten und unterhalb eines maximal möglichen Expansionshubs liegenden Stellhubs verbessert. Andererseits sind die konstruktiven bzw. aufwandsbedingten Nachteile von miteinander mechanisch und einander gegenseitig rückstellenden MSM-Einzelaktuatoren zu überwinden, so dass eine Aktuatorvorrichtung geschaffen werden soll, welche einen deutlich verbesserten (und den theoretischen maximalen kristallinen Expansionsmöglichkeiten angenäherten) nutzbaren Expansions- und Stellhub der Expansionsmittel kombiniert mit konstruktiver Einfachheit und zuverlässiger Rückstellbarkeit in eine Ausgangsposition.

Die Aufgabe wird durch die Aktuatorvorrichtung mit den Merkmalen des Hauptanspruchs gelöst, wobei erfindungsgemäß eine Aktuatorvorrichtung als Push-Push-System bestehend aus ersten und zweiten Stellmitteln (und mit lediglich einem MSM-System) geschaffen wird, die jeweils unabhängig voneinander ansteuer- bzw. bestrombar sind und so die prinzipiellen Funktionsvorteile bekannter Push-Push-Systeme gegenüber mit Federkraft zurückgestellten MSM-Einzelaktuatoren überwinden.

Dabei löst die vorliegende Erfindung die zugrunde liegende Aufgabe zusätzlich dadurch, dass nicht etwa beide erfindungsgemäßen Stellmittel ein magnetisch wirksames Formgedächtnis-Legierungsmaterial (MSM) aufweisen, vielmehr ist dies erfindungsgemäß lediglich für die ersten Stellmittel der Fall, dagegen sind die mit den ersten Stellmitteln über den Stellkörper verbundenen bzw. zusammenwirkenden zweiten Stellmittel zunächst zwar als ebenfalls elektrisch bestrom- und aktivierbar ausgestaltet (bzw. mit einem elektrischen Signal beaufschlagbar), weisen jedoch kein magnetisch wirksames Formgedächtnis-Legierungsmaterial auf. Vielmehr ist es für diese zweiten Stellmittel weiterbildungsgemäß möglich und bevorzugt, diese etwa mittels eines elektromagnetisch oder elektromotorisch betriebenen Aktors zu realisieren. Ergänzend oder alternativ sind diese zweiten Stellmittel mittels eines elektrisch ansteuerbaren Piezokristalls, eines Bimetalls, eines thermisch wirksamen Formgedächtnis-Legierungsmaterials, wiederum ergänzend oder alternativ mittels Hydraulik- oder Pneumatikmittel auszugestalten.

Alle diese Varianten ermöglichen es erfindungsgemäß, dass bei der ersten Bestromung (und damit einer Magnetfeldbeaufschlagung der MSM-Expansionsmittel der ersten Stellmittel) diese nicht etwa während ihrer Expansion durch eine Gegenkraft, insbesondere vor einem Erreichen eines Expansionsmaximums, gebremst oder gehalten werden, vielmehr ist es möglich, weitestgehend einen maximal möglichen (etwa durch die Kristallbedingungen des zur Realisierung der Expansionsmittel vorgesehenen MSM-Kristalls vorgegebenen) maximalen Expansionshub auszunutzen, so dass erfindungsgemäß mindestens 90%, weiter bevorzugt mindestens 95%, dieses Hubes auch tatsächlich in eine Bewegung des Stellkörpers umsetzbar sind. Erst eine geeignet angesteuerte Aktivierung der erfindungsgemäßen zweiten, nicht als MSM-Aktuator realisierten Stellmittel führt dann zu einer Rückstellung bzw., entsprechend einer jeweiligen Ansteuerung, zu einem Stellen des Stellkörpers in eine gewünschte Zwischenposition, welche, entsprechend den vorbeschriebenen Eigenschaften des magnetischen Formgedächtnis-Legierungsmaterials, stromlos stabil sein kann.

Während es im Rahmen der vorliegenden Erfindung vorgesehen ist, zur Realisierung des erfindungsgemäßen Push-Push-Systems der Aktuatorvorrichtung die zweiten Stellmittel explizit ohne magnetisch wirksames Formgedächtnis-Legierungsmaterial auszugestalten, ist es gleichwohl nicht ausgeschlossen, dass trotzdem eine Rückstellfunktionalität der zweiten Stellmittel durch mechanische Federmittel und/oder rückstellend eingerichtete Permanentmagnetmittel unterstützt werden kann, insbesondere dann, wenn etwa eine Kraft-Weg-Kennlinie einer derartigen Rückstell-Unterstützung so eingerichtet ist, dass diese im Bereich des expandierten Zustandes der Expansionsmittel eine vergleichsweise geringe Rückstellkraft ausübt. Während etwa das Zurückstellen mittels mechanischer Feder aus der DE 10 2005 038 891 A1 bekannt ist und im Hinblick auf eine Realisierung einer Federunterstützung bei der Rückstellung als zur Erfindung gehörig in die vorliegende Offenbarung einbezogen gelten soll, beschreibt etwa die DE 10 2012 107 014 der Anmelderin eine permanentmagnetische Rückstellung, bei welcher Permanentmagnetmittel eine Kontraktion der Expansionsmittel in die nicht-expandierte Ausgangsstellung unterstützen. Auch eine solche Technologie, in Verbindung den erfindungsgemäßen zweiten Stellmitteln, soll im Hinblick auf eine konkrete Realisierung einer bevorzugten Ausführungsform der vorliegenden Erfindung als zur Erfindung gehörig in die vorliegende Offenbarung einbezogen gelten.

In besonders bevorzugter Realisierung der vorliegenden Erfindung ist es vorgesehen, den erfindungsgemäßen Stellkörper entweder unmittelbar durch die (MSM-)Expansionsmittel zu realisieren oder mit diesen geeignet, weiter bevorzugt unlösbar, zu verbinden, vorstellbar ist hier etwa, dass ein geeignet geformter Kristallkörper zur Realisierung der Expansionsmittel selbst einends die Stellkörperfunktion ausübt, alternativ mit einem entsprechenden Abschnitt durch Verschweißen o.dgl. verbunden ist. Alternativ hierzu und wiederum im Rahmen einer vorteilhaften Ausbildung der Erfindung könnte dieser Stellkörper einen Ankerabschnitt, etwa einen Ankerstößel, der als Elektromagnet-Aktuator realisierten zweiten Stellmittel ausbilden, so dass in der erfindungsgemäßen Weise der Stellkörper die mechanische Verbindung zwischen den ersten (MSM-)Stellmitteln und den zweiten (nicht MSM-)Stellmitteln bildet. Es wird ebenso auf den Stand der Technik in den Dokumenten US20040206922 und US2006044093 Bezug genommen. In der praktischen Realisierung der Erfindung ist es dabei sowohl möglich, die Stellbewegungen (zumindest abschnittsweise) linear auszubilden, wobei dann etwa entsprechend einer derartigen Linie die Stellmittel aufeinander gerichtet wirken würden, ergänzend oder alternativ könnte die mechanische Verkoppelung über den Stellkörper (wiederum zumindest abschnittsweise) bogenförmig, insbesondere kreisbogenförmig, erfolgen, etwa in der Art der als gattungsbildend herangezogenen DE 10 2009 014 304.

Während es zudem gemäß einer ersten Realisierungsform der Erfindung und zur Verringerung konstruktiven Aufwandes in der Realisierung bevorzugt ist, die Expansionsmittel und einen Antriebskörper, etwa einen Stößel o.dgl., der zweiten Stellmittel möglichst unmittelbar auf den Stellkörper wirken zu lassen, ist es gleichwohl von der Erfindung umfasst, den ersten und/oder den zweiten Stellmitteln mechanisch wirksame Übersetzungs- bzw. Getriebemittel zuzuordnen, welche, ggf. zur Beeinflussung des Stellverhaltens im Hinblick auf Stellhub oder Stellkraft, eine Optimierung für einen jeweiligen Anwendungszweck ermöglichen.

Insbesondere ist es daher von der vorliegenden Erfindung umfasst, die erfindungsgemäße Aktuatorvorrichtung als Push-Push-Aktuator für eine Vielzahl von Stellzwecken einzusetzen, insbesondere wenn der Stellkörper in eine Mehrzahl von (bevorzugt stromlos stabilen) Zwischenpositionen zwischen Endpositionen der ersten und der zweiten Stellvorrichtung verbracht werden soll, auch wenn das Stellen lediglich einer derartigen Zwischenposition gleichermaßen von der Erfindung umfasst ist. Weiterbildungsgemäß hierzu kann es wiederum vorgesehen und von Vorteil sein, geeignet den ersten und/oder zweiten Stellmitteln Regelmittel so vorzuschalten, dass durch geeignete Regelfunktion auch bei Abweichungen einer derart eingestellten (Zwischen-)Position eine Regelung auf eine vorbestimmte Position erfolgen kann.

Im Ergebnis wird durch die erfindungsgemäße Aktuatorvorrichtung ein Weg geschaffen, die konstruktiven und prinzipbedingten Nachteile einer auf einen MSM-Einzelaktuator wirkenden Nachteile zu überwinden und gleichermaßen mit geringem Aufwand einen Push-Push-Aktuator zu schaffen, welcher nicht den konstruktiven Mehraufwand eines gekoppelten Paares von MSM-Einzelaktuatoren benötigt, bei gleichermaßen positivem und wirkungsvollem Schalt- und Bewegungsverhalten zwischen den jeweiligen Stell-Endpositionen der ersten und zweiten Stellmittel.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1: eine schematische Längsschnittdarstellung der erfindungsgemäßen Push-Push-Aktuatorvorrichtung gemäß einer ersten Ausführungs-form;
- Fig. 2: eine Realisierungsform der Aktuatorvorrichtung als zweites Ausführungsbeispiel, welches das Ausführungsbeispiel der Fig. 1 um mechanische Federmittel ergänzt;
- Fig. 3: eine Variante des Ausführungsbeispiels der Fig. 2, wobei die mechanischen Federmittel durch eine Permanentmagnetanordnung ersetzt sind und
- Fig. 4: ein weiteres Ausführungsbeispiel der Erfindung, wobei die zweiten Stellmittel ein thermisches Formgedächtnislegierungsmaterial aufweisen.

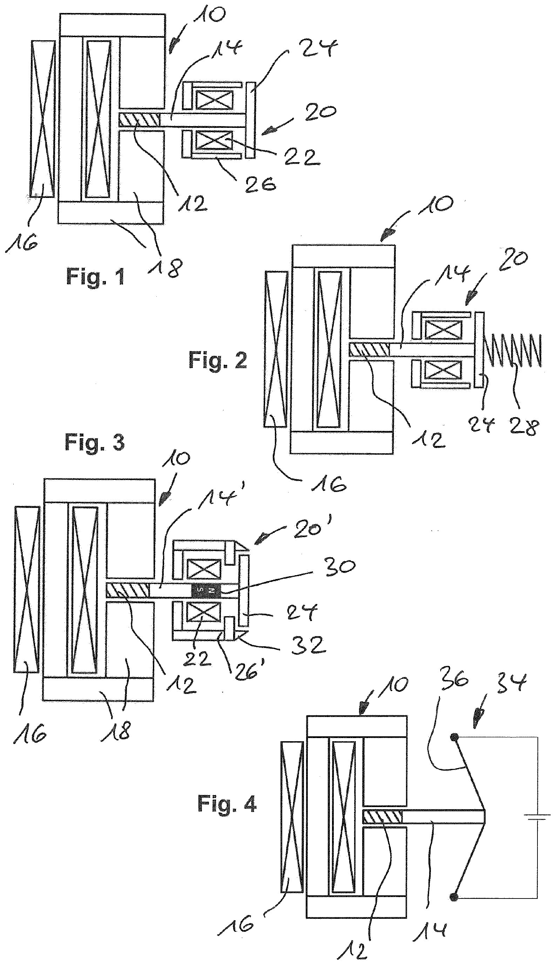

Das konzeptuelle Schemadiagramm der Fig. 1 verdeutlicht den prinzipiellen Aufbau der erfindungsgemäßen Aktuatorvorrichtung eines ersten Ausführungsbeispiels. So sind die ersten Stellmittel realisiert als MSM-Aktuator 10, aufweisend langgestreckte Expansionsmittel 12 in Form eines aus einem magnetischen Formgedächtnis-Legierungsmaterial realisierten Ansatzes (Fortsatzes) an einem Stößel 14.

In ansonsten bekannter Art wird als Reaktion auf eine Bestromung einer Spuleneinheit 16 der MSM-Körperabschnitt 12 mit einem Magnetfluss beaufschlagt, welcher über die in der Fig. 1 gezeigte flussleitende Kernanordnung 18 in Mantelflächen des MSM-Expansionskörpers eingetragen wird und in ansonsten bekannter Weise bei Überschreiten einer kritischen Magnetflussdichte die gewünschte Expansion, in der Figurenebene der Fig. 1 entlang der horizontalen Richtung, bewirkt.

Der einends den MSM-Expansionskörper 12 aufweisende Stößel ist, wie die Fig. 1 zeigt, gleichzeitig ein elektromagnetisch betätigter Anker der im rechten Bereich der Fig. 1 schematisch gezeigten Elektromagnetanordnung 20 als zweiten Stellmitteln in der Realisierung der Erfindung: Wiederum in ansonsten aus dem Stand der Technik allgemein bekannter Art wird dieser mittig in einer Spulenanordnung 22 bewegbar geführte Stößel betätigt durch einen elektromagnetischen Fluss, welcher bei Bestromung der Spuleneinheit 22 einen endseitigen Ankerabschnitt 24 (welcher zusammen mit dem Stößel 14 als Anker bewegbar ist) relativ zu einem stationären flussleitenden Gehäuse 26 angetrieben, um insoweit den Flusskreis für den elektromagnetisch erzeugten Fluss zu schließen.

Auf die in Fig. 1 konzeptuell gezeigte Weise entsteht somit ein Push-Push-Aktuator dergestalt, dass die ersten (MSM-)Stellmittel 10 als Reaktion auf eine Bestromung der ersten Spule 16 durch Expansion des Expansionskörpers 12 eine Stößelbewegung in der Figurenebene der Fig. 1 nach rechts auslösen und so den Stößel 14 als Stellkörper in eine gewünschte (in der Figurenebene horizontale) Position verbringen. Eine Bestromung der zweiten Spule 22 (idealerweise bei deaktivierter Bestromung der ersten Spule 16) führ dann zu einer Bewegung des Ankers 14, 24 in entgegengesetzter horizontaler Richtung (d.h. in der Figurenebene der Fig. 1 nach links) und stellt auf diese Weise den MSM-Expansionskörper 12, welcher durch geeignetes Verschweißen oder Verkleben mit dem Stößel 14 unlösbar verbunden ist, in seine komprimierte bzw. nicht-expandierte Ausgangslage zurück.

Auf diese Weise wird damit eine Rückstellung der MSM-Expansionsmittel 11 ermöglicht, ohne dass, insbesondere während eines Expansionsbetriebs, eine relevante Gegenkraft der Expansionsbewegung entgegenwirken würde, da im Regelfall während dieses Expansionsbetriebs keine Bestromung der Spule 22 zur Stößelbewegung 14 erfolgt. Vorteilhafte Konsequenz ist, dass praktisch ungehindert die Expansionsmittel 12 eine Expansionsbewegung bis zum Expansionsmaximum (d.h. innerhalb der kristallinen bzw. physikalisch gegebenen Möglichkeiten) durchführen können, wodurch in der Praxis mindestens 90% des maximalen (physikalischen) Expansionshubs, üblicherweise sogar mindestens 95% dieses maximalen Expansionshubs in die erfindungsgemäße Aktuatorbewegung entlang der ersten Stellrichtung umgesetzt werden kann.

Die Fig. 2 zeigt als Variante zum Ausführungsbeispiel der Fig. 1, dass zusätzlich vorgesehene Federmittel in Form einer schematisch gezeigten Druckfeder 28 den Anker 14, 24 der zweiten Stellmittel 20 entgegen der Expansionsrichtung der Expansionsmittel 12 vorspannen. Gleichzeitig ist eine Federkonstante dieser Federmittel 28 so gewählt, dass bei unbestromter Elektromagnet-Aktuatorvorrichtung (zweiten Stellmitteln) 20 die Federkraft nicht ausreicht, um den MSM-Körper 12 zu kontrahieren bzw. in seine nicht-expandierte Position zurückzustellen. Insoweit erhält die in der Fig. 2 schematisch gezeigte Feder 28 die Eigenschaft einer zusätzlichen, hybriden Verstärkung einer Rückstellwirkung, wie sie von der Elektromagnet-Aktuatorvorrichtung 20 entgegen der Expansionsrichtung des MSM-Körpers 12 durchgeführt wird. Im Rahmen der Erfindung liegt es dabei, durch geeignete Kombination verschiedener Wirkelemente, etwa der aktiv zu bestromenden zweiten Stellmittel in Verbindung mit (passiv wirkenden) zusätzlichen Federmitteln 28, ein gewünschtes Bewegungs-, Stell- und Rückstellverhalten der Gesamtanordnung zu erzeugen und zu beeinflussen. Auch weist das gezeigte Ausführungsbeispiel mit der Feder 28 den Vorteil auf, dass auf diese Weise eine (potentiell nachteilige, da mit erhöhtem Herstellungsaufwand verbundene bzw. schwierig zu montierende) einstückige Ausgestaltung der Einheiten 12, 14 vermieden werden kann; die Feder 28 würde bei einer derartigen, lösbaren Verbindung dafür sorgen, dass der (etwa bei komprimiertem Element 12) frei bewegbare Anker 12 stets mit (geringer) Kraft an das MSM-Element gebracht wird, so dass in beliebiger Einbaulage die Baugruppen 12, 14 verbunden sind (und etwa ein Kleben oder Schweißen od.dgl. zum Herstellen einer unlösbaren Verbindung unnötig wird).

Eine weitere Variante einer derartigen Vorgehensweise verdeutlicht das Ausführungsbeispiel der Fig. 3, wobei wiederum identische Bezugszeichen gleiche oder gleichwirkende Funktionskomponenten in allen gezeigten Ausführungsbeispielen darstellen.

Hier werden die zweiten Stellmittel 20' realisiert durch die innerhalb der Jochkern-Anordnung 26' vorgesehene Spuleneinheit 22, wobei der Stößel 14' in seinem Mittelbereich einen in der gezeigten Weise axial magnetisierten Permanentmagneten 30 aufweist. Zusätzlich ist endseitig der Jochkerneinheit zum Beeinflussen des magnetischen Flussverlaufes im Kreis eine Konusanordnung 32 vorgesehen, welche insoweit, im Zusammenwirken mit dem Ankerabschnitt 24, das Flussverhalten beeinflusst. Im Ausführungsbeispiel der Fig. 4 lässt sich so eine Betriebskennlinie (in der Art einer "Federkennlinie") erzeugen, welche, insbesondere im kritischen Endbereich der MSM-Expansion nahe des Maximalhubs, praktisch keine wirksame Feder-Gegenkraft aufbringt und so in der erfindungsgemäß vorteilhaften Weise eine vollständige Expansion der Expansionsmittel und mithin einen maximalen Stellhub der ersten Stellmittel gestattet. Auch sind, je nach Anwendungserfordernis und konkreter Ausgestaltung, die beschriebenen Instrumente des Permanentmagneten bzw. der Konusanordnung nicht notwendigerweise in Kombination anzuwenden; diese können auch jeweils einzeln bzw. unabhängig voneinander Anwendung finden.

Die Fig. 4 zeigt eine weitere Ausführungsform der vorliegenden Erfindung, wobei hier den ersten Stellmitteln (welche insoweit analog zu den Fig. 1 bis 3 ausgestaltet sind) zweite Stellmittel in Form eines thermischen Formgedächtnislegierungs-Aktors 34 zugeordnet sind. Genauer gesagt zeigt die Fig. 4 in der schematischen Darstellung, wie auf den Ankerstößel 14 ein aus einem Formgedächtnis-Legierungsmaterial 36 gebildeter Draht, beidends aufgehängt, so wirkt, dass bei einer Bestromung des FGL-Elements 36 und der dadurch (durch die mittels des ohmschen Widerstands erzeugte Wärme) bewirkten Kontraktion eine das Bauelement 12 rückstellende Kraftbeaufschlagung entsteht. Für den Fachmann ist es offensichtlich, dass das Schema der Fig. 4 auf verschiedene Weisen mechanisch-konstruktiv realisiert werden kann und etwa die Ausgestaltung des thermischen FGL als Draht exemplarisch für eine Vielzahl von möglichen Realisierungsvarianten samt Erwärmungstechnologie steht.

## Patentansprüche

1. Aktuatorvorrichtung zum bidirektionalen Stellen eines zum Zusammenwirken mit einem Stellpartner ausgebildeten, bevorzugt als Stößel realisierten Stellkörpers (14),
mit ersten Stellmitteln (10), die ein magnetisch wirksames Formgedächtnis-Legierungsmaterial auf einem Expansionsmittel (12) aufweisende, eine Stellkraft, insbesondere eine Schubkraft, zum Bewegen des Stellkörpers entlang einer ersten Stellrichtung auf das Expansionsmittel aufweisen,
die als Reaktion auf eine erste Bestromung von ersten Spulenmitteln (16) eine die Stellkraft erzeugende Expansion durchführen, wobei der Körperabschnitt mit dem Formgedächnis-Legierungsmaterial des Expansionsmittels mit einem Magnetfluss beaufschlagt wird, der über eine flussleitende Kernanordnung (18) in Mantelflächen der Expansionsmittel eingetragen wird,
und dem Stellkörper zugeordneten, von den Expansionsmitteln und der ersten Spuleneinheit getrennt vorgesehenen zweiten Stellmitteln (20; 20', 34), die zum Bewegen des Stellkörpers in einer der ersten Stellrichtung entgegengesetzten zweiten Stellrichtung ausgebildet sind,
wobei die zweiten Stellmittel einen elektromagnetisch angetriebenen, einen elektromagnetisch betätigten Anker (14, 24) und eine zweite Spule (22) aufweisenden Aktor aufweisen
und so zum Bewegen des Stellkörpers in der zweiten Stellrichtung einen als Reaktion auf eine Signalbeaufschlagung in Form einer zweiten elektrischen Bestromung der zweiten Spule aktivierbaren Antrieb ausbilden,
wobei der Stellkörper einen Ankerabschnitt, insbesondere Ankerstößel, der als Elektromagnet-Aktor (20) realisierten zweiten Stellmittel ausbildet.

2. Vorrichtung nach Anspruch 1,
**dadurch gekennzeichnet,**
**dass** die Expansionsmittel (12) so eingereichtet sind und mit dem Stellkörper zusammenwirken, dass bei der ersten Bestromung über mindestens 80%, bevorzugt über mindestens 90%, weiter bevorzugt über mindestens 95%, eines maximalen Expansionshubes der Expansionsmittel die Bewegung des Stellkörpers entlang der ersten Stellrichtung bewirkt wird.

3. Vorrichtung nach Anspruch 1 oder 2,
**dadurch gekennzeichnet,**
**dass** die ersten Stellmittel und die zweiten Stellmittel elektrische Ansteuermittel so vorgeschaltet aufweisen, dass der Stellkörper in mindestens einer Zwischenposition zwischen einer Endposition der ersten bzw. der zweiten Stellrichtung stromlos stabil gehalten werden kann.

4. Vorrichtung nach einem der Ansprüche 1 bis 3,
**dadurch gekennzeichnet,**
**dass** den zweiten Stellmitteln mechanische Federmittel (28) und/oder Permanentmagnetmittel (30) so zugeordnet sind, dass diese auf den Stellkörper eine in der zweiten Stellrichtung wirkende Feder- und/oder Magnetkraft ausüben.

5. Vorrichtung nach Anspruch 4,
**dadurch gekennzeichnet,**
**dass** die Feder- bzw. Magnetkraft so eingerichtet ist, dass sie kleiner ist als eine Rückstellkraft zum Verbringen der Expansionsmittel von einem expandierten in einen komprimierten Zustand.

6. Vorrichtung nach einem der Ansprüche 1 bis 5,
**dadurch gekennzeichnet,**
**dass** der Stellkörper (14) durch die Expansionsmittel (12) realisiert oder bevorzugt unlösbar mit diesen verbunden ist.

7. Vorrichtung nach einem der Ansprüche 1 bis 6,
**dadurch gekennzeichnet,**
**dass** dem Elektromagnet-Aktor Konusmittel (32) zur Beeinflussung des elektromagnetischen Stell- und/oder Kraftverhaltens zugeordnet sind.

8. Vorrichtung nach einem der Ansprüche 1 bis 7,
**dadurch gekennzeichnet, dass** eine mechanische Verkopplung der ersten und zweiten Stellmittel über den Stellkörper so realisiert ist, dass die Bewegung des Stellkörpers entlang der ersten bzw. zweiten Stellrichtung zumindest abschnittsweise linear oder bogenförmig, insbesondere kreisbogenförmig, erfolgt.

9. Vorrichtung nach einem der Ansprüche 1 bis 8,
**dadurch gekennzeichnet,**
**dass** die ersten und die zweiten Stellmittel so ausgebildet und aufeinander gerichtet sind, dass diese von, bezogen auf den Stellkörper, einander entgegengesetzten und/oder gegenüberliegenden Angriffspositionen mit dem Stellkörper zusammenwirken.

10. Verwendung der Aktuatorvorrichtung nach einem der Ansprüche 1 bis 9 als Push-Push-Aktuator zum Stellen des Stellkörpers in mindestens eine, bevorzugt eine Mehrzahl von, weiter bevorzugt stromlos stabile(n) Zwischenposition(en) zwischen Endpositionen der ersten und der zweiten Stellrichtung.

11. Verwendung nach Anspruch 10, **gekennzeichnet durch** dem ersten und/oder den zweiten Stellmitteln zugeordnete Regelmittel zum Halten des Stellkörpers in der mindestens einen Zwischenposition.

## Claims

1. An actuator device for the bi-directional positioning of a positioning body (14) designed to operate in conjunction with a positioning partner, and preferably implemented as a plunger,
with first positioning means (10), which, having a magnetically active shape memory alloy material on an expansion means (12), have a positioning force, in particular a thrust, for purposes of moving the positioning body along a first positioning direction onto the expansion means,
which in response to a first energisation of first coil means (16) execute an expansion generating the positioning force, wherein
the body section with the shape-memory alloy material of the expansion medium is subjected to a magnetic flux, which is introduced by way of a flux-conducting core arrangement (18) into outer surfaces of the expansion medium,
and second positioning means (20; 20', 34), associated with the positioning body, provided separately from the expansion means and the first coil unit, which are designed for purposes of moving the positioning body in a second positioning direction opposed to the first positioning direction, wherein
the second positioning means have an electromagnetically driven actuator, having an electromagnetically actuated armature (14, 24) and a second coil (22)
and thus for purposes of moving the actuator in the second positioning direction form a drive that can be activated in response to an application of a signal in the form of a second electrical energisation of the second coil, wherein
the positioning body forms an armature section, in particular an armature plunger, of the second positioning means implemented as an electromagnetic actuator (20).

2. The device in accordance with claim 1,
**characterised in**
**that** the expansion means (12) are arranged and operate in conjunction with the positioning body, such that with the first energisation the movement of the positioning body along the first positioning direction is effected over at least 80 %, preferably over at least 90 %, more preferably over at least 95 %, of a maximum expansion stroke of the expansion means.

3. The device in accordance with claim 1 or 2,
**characterised in**
**that** the first positioning means and the second positioning means have electrical control means connected upstream such that the positioning body can be maintained in a stable state without power in at least one intermediate position between an end position of the first or the second positioning direction.

4. The device in accordance with one of the claims 1 to 3,
**characterised in**
**that** mechanical spring means (28) and/or permanent magnetic means (30) are assigned to the second positioning means such that they exert a spring and/or magnetic force on the positioning body acting in the second positioning direction.

5. The device in accordance with claim 4,
**characterised in**
**that** the spring or magnetic force is arranged to be smaller than a restoring force for purposes of bringing the expansion means from an expanded state into a compressed state.

6. The device in accordance with one of the claims 1 to 5,
**characterised in**
**that** the positioning body (14) is implemented in terms of the expansion means (12), or preferably is non-detachably connected to the latter.

7. The device in accordance with one of the claims 1 to 6,
**characterised in**
**that** conical means (32) are assigned to the electromagnetic actuator for purposes of influencing the electromagnetic positioning and/or force behaviour.

8. The device in accordance with one of the claims 1 to 7,
**characterised in**
**that** a mechanical coupling of the first and second positioning means on the positioning body is implemented such that the movement of the positioning body along the first or second positioning direction takes place at least partially in a linear or arc-shaped, in particular a circular arc-shaped, manner.

9. The device in accordance with one of the claims 1 to 8,
**characterised in**
**that** the first and the second positioning means are designed and directed towards one another such that they operate in conjunction with the positioning body from opposing and/or opposed engagement positions with respect to the positioning body.

10. A use of the actuator device in accordance with one of claims 1 to 9 as a push-push actuator for purposes of positioning the positioning body in at least one, preferably a plurality of, intermediate position(s), more preferably in a stable state without power, between end positions of the first and the second positioning direction.

11. The use in accordance with claim 10, **characterised by** control means assigned to the first and/or second positioning means for purposes of maintaining the positioning body in the at least one intermediate position.

## Revendications

1. Dispositif d'actionneur pour le réglage bidirectionnel d'un corps de réglage (14) réalisé de 5préférence sous forme de poussoir, configuré pour coopérer avec un partenaire de réglage avec des premiers moyens de réglage (10), qui présentent un matériau d'alliage à mémoire de forme actif magnétiquement sur un moyen d'expansion (12), présentant une force de réglage, en particulier une force de poussée, pour déplacer le corps de réglage le long d'une première direction de réglage sur le moyen d'expansion, qui effectuent une expansion produisant la force de réglage en réaction à une première excitation de moyens de bobines (16), dans lequel la partie de corps avec le matériau d'alliage à mémoire de forme du moyen d'expansion est soumise à un flux magnétique, qui est introduit dans des faces latérales des moyens d'expansion via un agencement de noyau conducteur de flux (18), et des deuxièmes moyens de réglage (20, 20', 34) associés au corps de réglage, prévus séparément des moyens d'expansion et de la première unité de bobines, qui sont configurés pour le déplacement du corps de réglage dans une deuxième direction de réglage opposée à la première direction de réglage, dans lequel les deuxièmes moyens de réglage présentent un actionneur présentant un induit (14, 24) à entraînement électromagnétique, actionné de façon électromagnétique, et une deuxième bobine (22) et forment ainsi, pour déplacer le corps de réglage dans la deuxième direction de réglage, un entraînement pouvant être activé en réaction à la réception d'un signal sous la forme d'une deuxième excitation électrique de la deuxième bobine, dans lequel le corps de réglage forme une partie 5d'induit, en particulier un poussoir à induit, des deuxièmes moyens de réglage réalisés sous forme d'actionneur électromagnétique (20).

2. Dispositif selon la revendication 1, **caractérisé en ce que** les moyens d'expansion (12) sont conçus et coopèrent avec le corps de réglage, de telle manière que lors de la première excitation on provoque le mouvement du corps de réglage le long de la première direction de réglage sur au moins 80 %, de préférence sur au moins 90 %, de préférence encore sur au moins 95 % d'une course d'expansion maximale des moyens d'expansion.

3. Dispositif selon la revendication 1 ou 2, **caractérisé en ce que** les premiers moyens de réglage et les deuxièmes moyens de réglage présentent des moyens de commande connectés en amont, de telle manière que le corps de réglage puisse être maintenu de façon stable sans courant dans au moins une position intermédiaire entre une position terminale dans la première ou dans la deuxième direction de réglage.

4. Dispositif selon l'une quelconque des revendications 1 à 3, **caractérisé en ce que** des moyens de ressort mécaniques (28) et/ou des moyens d'aimants permanents (30) sont associés aux deuxièmes moyens de réglage, de telle manière qu'ils exercent sur le corps de réglage une force élastique et/ou une force magnétique agissant dans la deuxième direction de réglage.

5. Dispositif selon la revendication 4, **caractérisé en ce que** la force élastique et/ou la force magnétique est conçue de telle manière qu'elle soit inférieure à une force de rappel pour amener les moyens d'expansion d'un état expansé à un état comprimé.

6. Dispositif selon l'une quelconque des revendications 1 à 5, **caractérisé en ce que** le corps de réglage (14) est réalisé par les moyens d'expansion (12) ou est de préférence relié à ceux-ci de façon inséparable.

7. Dispositif selon l'une quelconque des revendications 1 à 6, **caractérisé en ce que** des moyens de cône (32) sont associés à l'actionneur électromagnétique pour influencer le comportement électromagnétique de réglage et/ou de la force.

8. Dispositif selon l'une quelconque des revendications 1 à 7, **caractérisé en ce qu'**un couplage mécanique des premiers et des deuxièmes moyens de réglage est réalisé par le corps de réglage, de telle manière que le mouvement du corps de réglage le long de la première ou de la deuxième direction de réglage soit au moins en partie linéaire ou en forme d'arc, en particulier en forme d'arc de cercle.

9. Dispositif selon l'une quelconque des revendications 1 à 8, **caractérisé en ce que** les premiers et les deuxièmes moyens de réglage sont configurés et orientés les uns vers les autres de telle manière que ceux-ci, par rapport au corps de réglage, coopèrent avec le corps de réglage à partir de positions d'action qui sont opposées l'une à l'autre et/ou qui se font face.

10. Utilisation du dispositif d'actionneur selon l'une quelconque des revendications 1 à 9 comme actionneur Push-Push pour le réglage du corps de réglage dans au moins une, de préférence dans une multiplicité de position(s) intermédiaire(s), de préférence encore stable(s) sans courant, entre des positions terminales dans la première et dans la deuxième direction de réglage.

11. Utilisation selon la revendication 10, **caractérisée par** des moyens de régulation associés aux premiers et/ou aux deuxièmes moyens de réglage pour le maintien du corps de réglage dans ladite au moins une position intermédiaire.
